# EUROPÄISCHE PATENTANMELDUNG

(11) **EP 2 141 504 A2**
(43) Veröffentlichungstag der Anmeldung: **06.01.2010**
(21) Anmeldenummer: 08106037.8
(22) Anmeldetag: 30.12.2008
(51) Int. Cl.: G01R 31/02

(54) **Elektronische Schaltung insbesondere zur Audio-Eingangs-AC-Diagnose**

(30) Priorität: 30.06.2008 DE 102008040027
(71) Anmelder: Robert Bosch GmbH, 70469 Stuttgart (DE)
(72) Erfinder: Heuer, Wolfgang, 31139, Hildesheim (DE)

(57) **Zusammenfassung**

Die Erfindung betrifft eine elektronische Schaltung (1) zur Audio-Eingangs-AC-Diagnose, insbesondere für ein elektronisches Gerät mit einem Eingang (7), welcher mit zumindest einem Nutzsignal von externen Quellen (20) beaufschlagbar ist, mit einer Nutzsignalverarbeitungseinheit (14), die im Signalweg (10) angeordnet ist, **dadurch gekennzeichnet, dass** die Schaltung (1) weiterhin beinhaltet: einen AC-Generator (2) zur Erzeugung eines AC-Signals im Infraschallbereich, einen Schalter (4) zum Aufschalten des AC-Signals des AC-Generators auf den Eingang (7), vorzugsweise einen Koppelkondensator zur auswertbaren Spannungsteilung des Infraschall Diagnosesignals mit dem Koppelkondensator oder der Ausgangsimpedanz der externen Quelle und eine Auswerteschaltung (8), welche das geteilte Signal des AC-Generators oder ein Nutzsignal von externen Quellen am Eingang (7) detektiert. Die Erfindung betrifft weiterhin ein diesbezügliches Gerät und ein diesbezügliches Verfahren.

## Beschreibung

### Technisches Gebiet

Die Erfindung betrifft eine elektronische Schaltung zur Audio-Eingangs-AC-Diagnose, insbesondere für Autoradios, Fahrerinformationssysteme, Navigationssysteme, TV-Geräte oder Musikabspielgeräte, wie beispielsweise Hi-Fi-Musikanlagen, gemäß dem Oberbegriff von Anspruch 1, ein elektronisches Gerät gemäß Anspruch 9 und ein diesbezügliches Verfahren nach Anspruch 10.

### Stand der Technik

Elektronische Geräte, wie beispielsweise Autoradios, Fahrerinformationssysteme, Navigationssysteme, TV-Geräte oder Hi-Fi-Musikanlagen sind typischer Weise mit einer NF-Quelle eingangsseitig verbunden. Dabei können Anschlussfehler auftreten. Nun ist es ein Interesse festzustellen, ob die an dem Eingang des elektronischen Geräts angeschlossene NF-Quelle auch ordnungsgemäß angeschlossen ist oder ein Kurzschluss gegen Masse vorliegt oder ein Kurzschluss gegen die Versorgungsspannung vorliegt. Daher wird typischer Weise zu Diagnosezwecken vor dem Betrieb des elektronischen Geräts ein Test durchgeführt, bei welchem der Eingang des Geräts mit einer Gleichspannung beaufschlagt wird, wobei die Gleichspannung über einen Spannungsteiler dann gemessen wird. Bei diesem Verfahren müssen die externen Geräte aber galvanisch an Masse liegen und dürfen ihre Ausgänge nicht kapazitiv getrennt haben.

Dies führt somit zu einschränkenden Randbedingungen für die externen Quellen oder Geräte und erlaubt die Diagnose nur vor dem Betrieb des elektronischen Geräts aber nicht während des Betriebs. Eine andauernde oder wiederkehrende Kontrolle während des Betriebs des Geräts kann so ebenso nicht realisiert werden.

### Darstellung der Erfindung: Aufgabe, Lösung, Vorteile

Es ist die Aufgabe der Erfindung, eine elektronische Schaltung, ein elektronisches Gerät und ein diesbezügliches Verfahren zu schaffen, mittels welcher bzw. mittels welchem eine Kontrolle eines Anschlusses an einen Eingang einer elektronischen Schaltung oder eines elektronischen Geräts durchführbar ist, die auch während des Betriebs der Schaltung oder des Geräts durchführbar ist.

Dies wird bezüglich der elektronischen Schaltung erreicht mit den Merkmalen von Anspruch 1, wonach eine elektronische Schaltung insbesondere zur Audio-Eingangs-AC-Diagnose beschrieben ist, insbesondere für ein elektronisches Gerät mit einem Eingang, welcher mit Nutzsignalen von externen Quellen beaufschlagbar ist, mit einer Nutzsignalverarbeitungseinheit, die im Signalweg angeordnet ist, wobei die Schaltung weiterhin beinhaltet: einen AC-Generator zur Erzeugung von einem AC-Signal im Infraschallbereich, einen Schalter zum Aufschalten des AC-Signals des AC-Generators auf den Eingang und eine Auswerteschaltung, welche das Signal des AC-Generators über einen Koppelkondensator als Spannungsteiler mit dem Koppelkondensator oder der Ausgangsimpedanz der externen Quelle oder ein Nutzsignal von externen Quellen am Eingang detektiert.

Dabei ist es erfindungsgemäß zweckmäßig, wenn vor der Nutzsignalverarbeitungseinheit ein Hochpassfilter vorgeschaltet ist zur Ausfilterung des AC-Signals des AC-Generators. Dadurch wird vorteilhaft erreicht, dass das AC-Signal des AC-Generators nicht in den weiteren Verarbeitungsweg gelangt und dort unerwünschte parasitäre Effekte verursacht.

Auch ist es zweckmäßig, wenn dem AC-Generator nachgeschaltet ein Impedanzwandler angeordnet ist.

Weiterhin ist es zweckmäßig, dass zwischen dem Impedanzwandler und dem Eingang eine Kapazität zur Gleichspannungsentkopplung geschaltet ist, die über den Koppelkondensator als Spannungsteiler mit dem Koppelkondensator oder der Ausgangsimpedanz der externen Quelle arbeitet.

Gemäß des erfindungsgemäßen Gedankens ist es weiterhin zweckmäßig, wenn der oben beschriebene Schalter ein elektronischer Schalter ist. Dadurch kann ein Schalten sehr schnell realisiert werden.

Auch ist es zweckmäßig, wenn die Auswerteschaltung ein Prozessor ist oder umfasst. Dies erlaubt eine schnelle Auswertung der Daten und gleichzeitig kann der Prozessor kostengünstig realisiert werden.

Dabei ist es besonders zweckmäßig, wenn das AC-Signal im Infraschallbereich im Frequenzbereich von 0,5 bis 20 Hz liegt, vorzugsweise im Bereich von ca. 3 bis 10 Hz, höchst vorzugsweise im Bereich von 5 Hz.

Auch ist es vorteilhaft, wenn die Grenzfrequenz des Hochpassfilters im Bereich von etwa 20 Hz bis etwa 50 Hz liegt.

Die Aufgabe der Erfindung bezüglich des elektronischen Geräts wird gelöst durch ein elektronisches Gerät mit einer obigen elektronischen Schaltung, bei welcher das Gerät ein Autoradio, ein Fahrerinformationssystem, ein Navigationssystem, ein TV-Gerät oder ein Musikgerät, wie beispielsweise eine Hi-Fi-Musikanlage ist.

Die Aufgabe der Erfindung bezüglich des Verfahrens wird gelöst durch ein Verfahren zur Audio-Eingangs-AC-Diagnose für eine elektronische Schaltung insbesondere eines elektronischen Geräts mit einem Eingang, welcher mit Nutzsignalen von externen Quellen beaufschlagbar ist, mit einer Nutzsignalverarbeitungseinheit, die im Signalweg angeordnet ist, wobei mittels eines AC-Generator ein AC-Signal im Infraschallbereich erzeugt wird, welches mittels eines Schalters über einen Kondensator als Spannungsteiler mit dem Koppelkondensator der externen Quelle auf den Eingang geschaltet wird und welche die geteilte Spannung weiterhin mittels einer Auswerteschaltung das Signal des AC-Generators oder ein Nutzsignal von externen Quellen am Eingang detektiert.

Weitere erfindungsgemäße Vorteile werden durch die Unteransprüche beschrieben.

### Kurze Beschreibung der Zeichnungen

Nachstehend wird die Erfindung auf der Grundlage eines Ausführungsbeispiels anhand der Zeichnungen näher erläutert. Es zeigen:

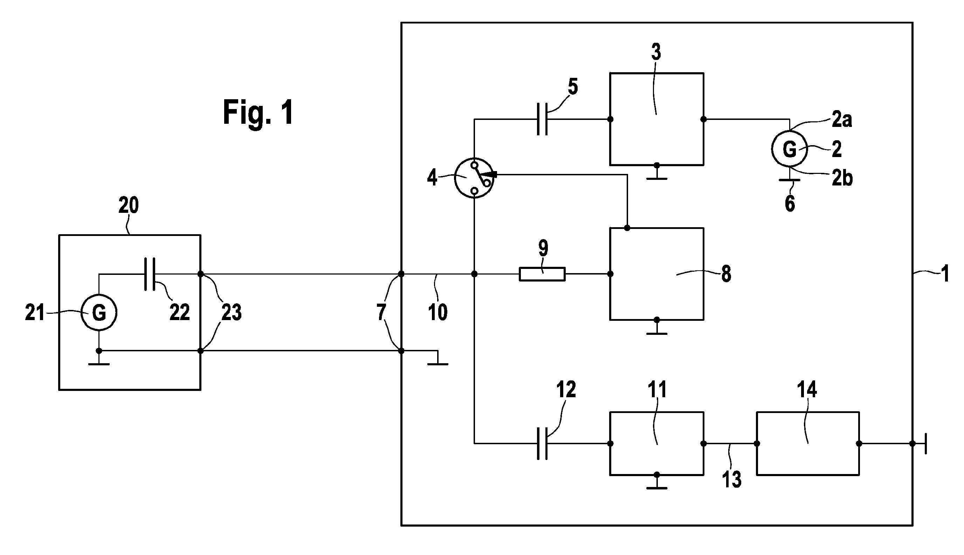

- Fig. 1: zeigt eine schematische Darstellung einer elektronischen Schaltung zur Audio-Eingangs-AC-Diagnose.

### Bevorzugte Ausführung der Erfindung

Die Figur 1 zeigt schematisch eine elektronische Schaltung 1 eines elektronischen Geräts, wie beispielsweise eines Navigationssystems, eines Fahrerinformationssystems, eines Autoradios, eines Fernsehgeräts bzw. TV-Gerät und/oder eines Musikabspielgeräts, wie beispielsweise einer Hi-Fi-Musikanlage. Die Schaltung enthält einen AC-Generator 2, welcher vorzugsweise ein AC-Signal im Infraschallbereich, wie beispielsweise Bereich von etwa 5 Hz, erzeugt. Das AC-Signal kann dabei ein Sinussignal oder ein anderweitig moduliertes AC-Signal sein, das mit einer Frequenz im Infra-Schallbereich, vorzugsweise in einem Frequenzbereich unterhalb von ca. 20 Hz, also von etwa 0,5 Hz bis 20 Hz moduliert ist.

Die elektronische Schaltung 1 umfasst weiterhin einen Impedanzwandler 3, eine Kapazität 5 und einen Schalter 4. Der Schalter 4 kann dabei vorteilhaft ein elektronischer Schalter, wie beispielsweise ein Schalttransistor, sein. Dadurch kann das Schalten deutlich schneller durchgeführt werden und ein solcher elektronischer Schalter reduziert die kosten der Schaltung.

Dabei ist der AC-Generator 2 mit seinem Pluspol 2a mit dem Impedanzwandler 3 verbunden und mit seinem Minuspol 2b mit Masse 6. Der Impedanzwandler 3 selbst ist wiederum über die Kapazität 5 mit dem Schalter 4 verbunden. Ein Kontakt des Schalters 4 ist mit dem Eingang 7 der elektronischen Schaltung verbunden.

Dadurch kann eine Wechselspannung im Infraschallbereich auf den Niederfrequenzeingang 7 der elektronischen Schaltung eines elektronischen Geräts 1 gegeben werden, um zu testen, ob eine an dem Eingang 7 angeschlossenen NF-Quelle 20 ordnungsgemäß angeschlossen ist.

Die Quelle 20 ist im vorliegenden Beispiel durch eine NF-AC-Generator 21 und eine Kapazität 22 ausgebildet.

Durch die Verwendung eines Signals des AC-Generators 2 im Infraschallbereich erfolgen die Verwendung und die Diagnose unhörbar und kann daher vorteilhaft auch während des Betriebs des Gerätes mit der elektronischen Schaltung 1 durchgeführt werden. Dabei kann die Überprüfung während des Betriebs sowohl permanent, kontinuierlich oder auch zeitlich variabel durchgeführt werden.

Dabei wird auch zur Unterscheidung einer Signalpause der Quelle 20 von einem Kurzschluss nach Masse, bei welchen bei beiden Situationen kein Signal vorliegt, folgende elektronische Schaltung umgesetzt. Mit dem internen AC-Generator 2 wird eine niederfrequente Wechselspannung im Infraschallbereich erzeugt, die über den Impedanzwandler 3 und eine Kapazität 5 zur Gleichspannungsentkopplung und Spannungsteilung über den Schalter 4 auf den Eingang 7, welcher zu testen ist, geschaltet.

Über den Ausgang 23 der angeschlossenen Quelle 20 und deren Koppelkondensator 22, der bei der niedrigen Frequenz im Infraschallbereich einen deutlichen Widerstand darstellt, erfolgt eine Spannungsteilung mit dem in Reihe geschalteten internen Kondensator 5 der elektronischen Schaltung 1. Die entsprechend zu erwartende Spannung ist bei Kurzschluss gegen Masse nahe 0 V. Bei einer ungestörten Funktion ist die erwartete Spannung in einem endlichen Bereich, die größer als 0 V ist aber die auch kleiner als die Versorgungsspannung ist.

Bei einem Kurzschluss gegen die Versorgungsspannung ist jedoch permanent eine Spannung zu messen, die größer ist als das Wechselspannungsmaximum.

Bei einer Unterbrechung der Verbindung am Eingang 7 ist die Höhe der Wechselspannung gleich der Generatorleerlaufspannung. Somit sind alle vier möglichen Zustände, der ungestörte Betrieb, der Kurzschluss nach Masse, der Kurzschluss mit Versorgungsspannung und die Unterbrechung detektierbar und vorteilhaft auch voneinander zu unterscheiden. Diese Zustände sind vorteilhaft mit einer angeschlossenen Auswertschaltung 8, wie beispielsweise mit einem Prozessor erkennbar bzw. diagnostizierbar. Dabei ist die Auswerteschaltung 8 über einen Widerstand 9 an den Eingang 7 der Schaltung 1 angeschlossen.

Zur Diagnose wird die intern mittels des Generators 2 erzeugte Wechselspannung zu Diagnosezwecken auf den Signalweg 10 geschaltet. Bei einem messbaren Nutzsignal, wie beispielsweise bei einem Musiksignal kann die Auswertschaltung 8 das vorliegende Signal erkennen. Liegt ein Nutzsignal vor, so wird ein ordnungsgemäßer Anschluss am Eingang 7 angenommen. Vorzugsweise nur bei einem fehlenden Nutzsignal am Eingang 7, wie beispielsweise bei Pausen zwischen zwei Musikstücken oder bei einem anderweitigen Fehlen des Nutzsignals, wird die interne Wechselspannung im Infraschallbereich über einen Kondensator 5 als Spannungsteiler mit dem Koppelkondensator 22 der externen Quelle 20 auf den Eingang 7 geschaltet und ein Signal am Eingang diagnostiziert.

Um die im weiteren Signalweg 10 jedoch nicht benötigte Wechselspannung des Generators 2 zu unterdrücken, da sie beispielsweise in einer nachgeschalteten Leistungsendstufe auch unerwünschte Verlustleistung verursachen könnte, wird vor einer weiteren Verarbeitung des Nutzsignals das im Generator erzeugte Wechselspannungssignal mit einem Hochpass 11 und einer diesem vorgeschalteten Kapazität 12 zu unterdrücken versucht. Dazu wird dem Eingang 13 der weiteren Nutzsignalverarbeitung 14 der Hochpassfilter 11, beispielsweise 2. Ordnung oder höher, mit einer Grenzfrequenz von 10Hz bis 20 Hz vorgeschaltet.

## Patentansprüche

1. Elektronische Schaltung (1) insbesondere zur Audio-Eingangs-AC-Diagnose, insbesondere für ein elektronisches Gerät mit einem Eingang (7), welcher mit Nutzsignalen von externen Quellen (20) beaufschlagbar ist, mit einer Nutzsignalverarbeitungseinheit (14), die im Signalweg (10) angeordnet ist, **dadurch gekennzeichnet, dass** die Schaltung (1) weiterhin beinhaltet:
- einen AC-Generator (2) zur Erzeugung von einem AC-Signal im Infraschallbereich,
- einen Schalter (4) zum Aufschalten des AC-Signals des AC-Generators auf den Eingang (7) und
- eine Auswerteschaltung (8), welche das AC-Signal des AC-Generators oder ein Nutzsignal von externen Quellen am Eingang (7) detektiert.

2. Elektronische Schaltung (1) nach Anspruch 1, **dadurch gekennzeichnet, dass** vor der Nutzsignalverarbeitungseinheit (14) ein Hochpassfilter (11) vorgeschaltet ist zur Ausfilterung des AC-Signals des AC-Generators (2).

3. Elektronische Schaltung (1) nach Anspruch 1 oder 2, **dadurch gekennzeichnet, dass** dem AC-Generator (2) nachgeschaltet ein Impedanzwandler (3) angeordnet ist.

4. Elektronische Schaltung nach einem der vorhergehenden Ansprüche, **dadurch gekennzeichnet, dass** zwischen den Impedanzwandler (3) und den Eingang (7) eine Kapazität zur Gleichspannungsentkopplung geschaltet und/oder zur auswertbaren Spannungsteilung des Infraschall -Diagnosesignals ist.

5. Elektronische Schaltung nach einem der vorhergehenden Ansprüche, **dadurch gekennzeichnet, dass** der Schalter ein elektronischer Schalter ist.

6. Elektronische Schaltung nach einem der vorhergehenden Ansprüche, **dadurch gekennzeichnet, dass** die Auswerteschaltung (8) ein Prozessor ist oder umfasst.

7. Elektronische Schaltung nach einem der vorhergehenden Ansprüche, **dadurch gekennzeichnet, dass** das AC-Signal im Infraschallbereich im Frequenzbereich von 0,5 bis 20 Hz liegt, vorzugsweise im Bereich von ca. 3 bis 10 Hz, höchst vorzugsweise im Bereich von 5 Hz.

8. Elektronische Schaltung (1) nach einem der vorhergehenden Ansprüche, **dadurch gekennzeichnet, dass** die Grenzfrequenz des Hochpassfilters im Bereich von etwa 20 Hz bis etwa 50 Hz liegt.

9. Elektronisches Gerät mit einer elektronischen Schaltung (1) nach zumindest einem der vorhergehenden Ansprüche, **dadurch gekennzeichnet, dass** das Gerät ein Autoradio, ein Fahrerinformationssystem, ein Navigationssystem, ein TV-Gerät, ein MP3-Player oder ein ähnliches Speichermedium mit komprimierten Audiosignalen oder ein Musikabspielgerät, wie beispielsweise eine Hi-Fi-Musikanlage ist.

10. Verfahren insbesondere zur Audio-Eingangs-AC-Diagnose für eine elektronische Schaltung (1) eines elektronischen Geräts mit einem Eingang (7), welcher mit Nutzsignalen von externen Quellen (20) beaufschlagbar ist, mit einer Nutzsignalverarbeitungseinheit (14), die im Signalweg (10) angeordnet ist, **dadurch gekennzeichnet, dass** mittels eines AC-Generator (2) ein AC-Signal im Infraschallbereich erzeugt wird, das mittels einem Schalter (4) auf den Eingang (7) geschaltet wird und über einen Kondensator (5) als Spannungsteiler mit dem Koppelkondenstor (22) oder der Ausgangsimpedanz der externen Quelle (20) geschaltet wird und weiterhin mittels einer Auswerteschaltung (8) das Signal des AC-Generators oder ein Nutzsignal von externen Quellen am Eingang (7) detektiert wird.
